# EUROPEAN PATENT APPLICATION

(11) **EP 2 241 895 A1**
(43) Date of publication of application: **20.10.2010**
(21) Application number: 09711032.4
(22) Date of filing: 21.01.2009
(51) Int. Cl.: G01N 35/08, B81B 1/00, G01N 37/00

(54) **MICROCHIP AND METHOD FOR MANUFACTURING THE SAME**

(30) Priority: 15.02.2008 JP 2008034687
(71) Applicant: Konica Minolta Opto, Inc., Hachioji-shi, Tokyo 192-8505 (JP)
(72) Inventor: HIRAYAMA, Hiroshi, Hachioji-shi Tokyo 192-8505 (JP); HATANO, Takuji, Hachioji-shi Tokyo 192-8505 (JP)
(74) Representative: Henkel, Feiler & Hänzel
(86) International application number: PCT/JP2009/050826
(87) International publication number: WO 2009/101845

(57) **Abstract**

Provided are a microchip formed by joining a resinous film onto a resinous substrate, which enables the prevention of a leak due to peeling of a peripheral portion and prevention of deformation and clogging of a microchannel, and a method for manufacturing the same. The microchip comprises a resinous substrate including a first surface in which a channel groove is formed and a second surface on the side opposite to the first surface, and a resinous film joined to the first surface of the resinous substrate. A joint plane between the resinous substrate and the resinous film is composed of a central area including an area in which the channel groove is formed and a peripheral area corresponding to the outer periphery of the central area, the joint strength between the resinous substrate and the resinous firm in the central area is larger than 0.098 N/cm, and the joint strength in at least part of the peripheral area of the joint plane is larger than the joint strength in the central area.

## Description

### TECHNICAL FIELD

The present invention relates to a microchip which comprises flow passages and a method for manufacturing the same.

### BACKGROUND ART

Flow passages and circuits are formed by the utilization of microfabrication technology in such a way that microscopic grooves for flow passages are formed on a silicon or glass substrate and a plate-shaped sealing member is joined on the substrate, whereby a device called a micro analysis chip or µTAS (Micro Total Analysis Systems) to conduct a chemical reaction of liquid samples, such as nucleic acid, protein and blood, separation or analysis in a microscopic space is put in practical use.

Further, from the demands for the reduction of manufacturing cost, it is considered to manufacture a micro analysis chip with a resin-made base board and a resin-made sealing member.

As a method for joining the resin-made sealing member (a sealing member made of resin) to the resin-made base board (a base board made of resin), a method of utilizing adhesives, a method of joining by dissolving a resin surface with a solvent, a method of utilizing ultrasonic welding, a methods of utilizing laser welding, a method of utilizing heat welding, etc. are well known. However, in the case where a plate-shaped sealing member is joined so as to form flow passages, even if distortion or warp takes place slightly in the configuration of a base material and a sealing member, it becomes difficult to produce flow passages with uniformity. Accordingly, in the case ofproducing a micro analysis chip required particularly with high precision, it becomes a problem.

Then, it is considered to manufacture a micro analysis chip by joining a resin film to a resin-made base board in which microscopic grooves for flow passages are formed. That is, the micro analysis chip is produced by a resin-made base board in which grooves for flow passages are formed on its surface and through holes (reagent introduction, discharge holes) are formed at terminal points of grooves for flow passages, and a resin-made film joined to the surface of the resin-made base board.

As a procedure of joining a resin-made base board and a resin-made film, as with the micro analysis chip consisting of the abovementioned resin-made base board and the plate-shaped sealing member, a method of utilizing adhesives, a method of joining by dissolving a resin surface with a solvent, a method of utilizing ultrasonic welding, a method of utilizing laser welding, a method of utilizing heat welding by a flat plate-shaped or roll-shaped pressing device, etc. are well known. Especially, since a heat welding can be carried out at low cost, it is suitable as the joining method on the presupposition of mass production.

As such a micro analysis chip, proposed in a microchip in which on a base board made of acrylic resins, such as polymethylmethacrylate, heat welded is a film made of the same acrylic resin (for example, Patent Document 1).

However, in the micro analysis chip in which the resin-made film is joined to the resin-made base material, exact analysis may be disturbed by the deformation of microscopic flow passages in a manufacturing process and liquid leakage of an analysis sample. Accordingly, several improvements are required.

Patent document 1: Japanese Unexamined Patent Publication No. 2000-310613

### DISCLOSURE OF INVENTION

### PROBLEMS TO BE SOLVED BY THE INVENTION

At the time that analysis is conducted with a micro analysis chip, in order to maintain analysis accuracy, a step of fixing a micro analysis chip is generally conducted, for example, fixing members, such as positioning pins, are brought in contact with a periphery of a micro analysis chip or the sides and top of a micro analysis chip are held by a claw-shaped positioning jig. However, in this case, it turns out that a resin-made film provided to the peripheral section is peeled off from the resin-made base board, and problems, such as liquid leakage, may arise.

Further, in the case where a micro analysis chip is conveyed, in order to avoid the contact with flow passages, the micro analysis chip is conveyed while the sides of the micro analysis chip is supported by hands or a conveying device. In this case, a resin-made film provided to the peripheral section is also peeled off, causing liquid leakage.

However, since flow passages provided in a micro analysis chip are extremely microscopic, if an amount of adhesive is increased, or a pressure at the time of heat welding is increased in order to increase the joining force between the resin-made film and the resin-made base board, there is fear that the configuration of flow passages may deform in the manufacturing process or flow passages may be clogged, which makes it difficult to obtain stable analysis accuracy. Accordingly, there is no effective counter measure and several improvements are required.

The present invention is devised to solve the abovementioned problems, and an object of the invention is to provide a microchip and a producing method of the same, which can avoid liquid leakage due to peel-off of peripheral sections and further avoid the deformation and blockage of microscopic flow passages in a microchip in which a resin-made film is joined on a resin-made base board.

### MEANS FOR SOLVING PROBLEMS

In order to solve the above-mentioned problem, the invention described in claim 1 is a microchip which comprises a resin-made base board having a first surface in which grooves for flow passages are formed and a second surface at the opposite side of the first surface, and a resin-made film joined to the first surface of the resin-made base board, the microchip is **characterized in that** the joined surfaces of the resin-made base board and the resin-made film consists of a central region including a region in which the grooves for flow passages are formed and a peripheral region corresponding to the outer periphery of the central region, the joining strength of the resin-made base board and the resin-made film in the central region is larger than 0.098 N/cm, and the joining strength of at least a part of the peripheral region of the joined surfaces is larger than the joining strength of the central region.

The invention described in claim 2 is **characterized in that** in the microchip described in claim 1, a non joined region in which the resin-made film is not provided is provided in a partial region including a side edge of the first surface of the resin-made base board.

The invention described in claim 3 is a microchip which comprises a resin-made base board having a first surface in which grooves for flow passages are formed and a second surface at the opposite side of the first surface, and a resin-made film joined to the first surface of the resin-made base board, the microchip is **characterized in that** the joining strength of the resin-made base board and the resin-made film is larger than 0.098 N/cm, and a non joined region in which the resin-made film is not provided is provided in a partial region including a side edge of the first surface of the resin-made base board.

The invention described in claim 4 is a producing method of a microchip characterized by comprising:
a first joining process to join a resin-made film on a first surface of a resin-made base board having the first surface in which grooves for flow passages are formed and a second surface at the opposite side of the first surface, thereby forming a central region including a region in which the grooves for flow passages are formed and a peripheral region corresponding to the outer periphery of the central region; and
a second joining process to strengthen the joining strength of at least a partial region of the peripheral region of the joined surfaces after the first joining process,
wherein the joining strength of the resin-made base board and the resin-made film in the central region is larger than 0.098 N/cm.

### EFFECT OF THE INVENTION

According to the invention described in claim 1, in the joined surfaces of a resin-made base board and a resin-made film, when the joining strength of at least a part of a peripheral region provided at the periphery of a central region including microscopic flow passages is made larger than the joining strength of the central region, it becomes possible to refrain film peel-off and liquid leakage from the peripheral region of the joined surfaces being main factors of failures at the time of analysis without causing the deformation of the microscopic flow passages. Further, when the joining strength of the central region of the joined surfaces is made larger than 0.098 N/cm, it becomes possible to prevent liquid leakage from taking place at the microscopic flow passages due to firm peel-off from the peripheral region. The joining strength at the central region of the joined surfaces can be suitably adjusted to a joining strength not to cause the deformation of flow passages within the range of larger than 0.098 N/cm.

According to the invention described in claim 2, at the time of analysis with a micro analysis chip, when a fixing member is made to come in contact with the non joined region, it becomes possible to further refrain problems, such as film peel-off. Further, at the time of conveying the micro analysis chip, when the micro analysis chip is conveyed on the condition that a conveying tool or a hand is made to come in contact with the non joined region, it becomes possible to further refrain problems, such as film peel-off.

According to the invention described in claim 3, problems, as same as claim 2, at the time of analysis with a micro analysis chip, when a fixing member is made to come in contact with the non joined region, it becomes possible to further refrain problems, such as film peel-off. Further, at the time of conveying the micro analysis chip, when the micro analysis chip is conveyed on the condition that a conveying tool or a hand is made to come in contact with the non joined region, it becomes possible to further refrain problems, such as film peel-off. Further, when the joining strength of the central region of the joined surfaces is made larger than 0.098 N/cm, it becomes possible to prevent liquid leakage from taking place at the microscopic flow passages due to film peel-off from the peripheral region. The joining strength at the central region of the joined surfaces can be suitably adjusted to a joining strength not to cause the deformation of flow passages within the range of larger than 0.098 N/cm.

Furthermore, according to the invention described in claim 4, the micro analysis chip which is described in claim I and refrains film peel-off and liquid leakage can be manufactured by a simple method without causing the deformation of microscopic flow passages.

### BRIEF DESCRIPTION OF THE DRAWINGS

Fig. 1a is a plan view of a microchip according to an embodiment of this invention, and Fig. 1b is an IB-IB line cross sectional view of Fig. 1a.
Fig. 2a is a plan view of a microchip in which an edge of a resin-made film is arranged inside toward a central region of a resin-made base board, and Fig. 2b is an IB-IB line cross sectional view of Fig. 2a.
Fig. 3 is a diagram showing a range of strength with which a resin-made film is joined on a surface of a resin-made base board.
Fig. 4 is a cross sectional view of a microchip in which a resin-made film joined on the surface of the resin-made base board is rejoined with adhesive.
Fig. 5a is an explanatory drawing of a slide test of a microchip by the use of a positioning jig, and Fig. 5b is a VB-VB line cross sectional views of Fig. 5a.

### EXPLANATION OF REFERENCE SYMBOLS

- 10: Resin-made base board
- 11: Groove for flow passages
- 12: Top surface
- 13: Bottom surface
- 14: Wall surface
- 15: Through hole
- 17: Center region
- 18: Peripheral region
- 181: Side edge
- 20: Resin-made film
- 21: Lower surface
- 22: End edge
- 30: Positioning pin
- 40: Adhesive
- 50: Positioning jig

### BEST MODE OF CARRYING OUT THE INVENTION

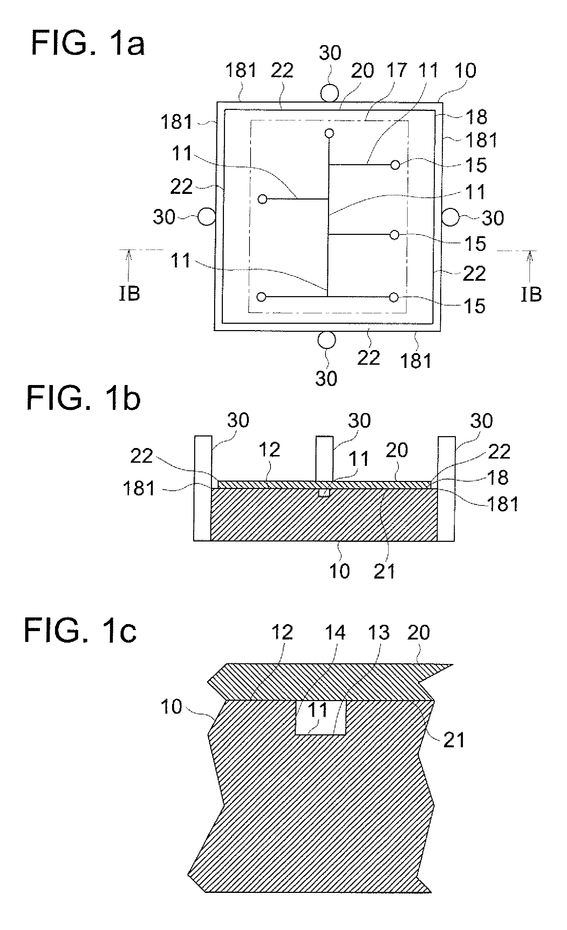

A microchip (there may be a case that it is called a micro analysis chip) according to an embodiment of the present invention and a production method of it are explained with reference to Fig. 1. Fig. 1a is a plan view of a microchip according to an embodiment of this invention, Fig. Ibis an IB-IB line cross sectional view of Fig. 1a, and Fig. 1c is an enlarged cross sectional view of a microscopic flow passage.

### (Structure of a microchip)

As shown in Figs. 1 a and 1b, grooves 11 for flow passages are formed on a surface 12 (it may be called a first surface) of the resin-made base board 10. Onto the surface 12 of the resin-made base board 10 on which the grooves 11 for flow passages are formed, a resin-made film 20 is joined. When the resin-made film 20 is joined to the resin-made base board 10, a microchip is manufactured. The joined surfaces of the surface 12 of the resin-made base board 10 and the lower surface 21 of the resin-made film 20 correspond to a joint surface of the microchip.

As shown in Figs. 1a and 1c, a microscopic flow passage is constituted by a bottom surfaces 13 and wall surfaces 14 of the groove for flow passages 11 and the lower surface 21 of the resin-made film 20.

In order to inject a liquid sample (a test sample for analysis, a solvent sample, a reagent) into the microscopic flow passage in a microchip, a hole called a through hole 15 is formed. This hole is also called a well. Usually, the through hole 15 is provided at a terminal point or a middle point of the groove 11 for flow passage of the resin-made base board 10 and is formed when the resin-made film 20 is pasted on the surface 12 of the resin-made base board 10. A liquid sample is introduced from a surface (it may be called a second surface) opposite to the surface 12 on which the resin-made film 20 is pasted.

Resin is used for the resin-made base board 10 and the resin-made film 20. Examples of conditions used as such a resin include good moldability (transfer ability, mold-release characteristic), high transparency, and a low autofluorescence property for ultraviolet radiation and visible light without being limited thereto specifically. Preferable examples of the resin include polycarbonate, polymethyl methacrylate, polystyrene, Polyacrylonitrile, polyvinyl chloride, polyethylene terephthalate, Nylon 6, Nylon 66, polyvinyl acetate, polyvinylidene chloride, polypropylene, polyisoprene, polyethylene, polydimethyl siloxane, cyclic polyolefin, and the like. Among them, in particular, polymethyl methacrylate, cyclic polyolefin and the like are desirable. For the resin-made base board 10 and the resin-made film 20, the same material may be used, or different materials may be used.

As long as the configuration of the resin-made base board 10 makes it easy to handle the microchip and to conduct analysis, the configuration is made in any configuration. For examples, the configuration is made preferably in a size of about 10 mm square to 200 mm square, more preferably 10 mm square to 100 mm square. The configuration of each of the resin-made base board 10 and the resin-made film 20 may be matched with an analyzing method and an analyzing apparatus and may be made in a square, a rectangle, and a circle.

In consideration for the capability of making the used amount of each of a test sample for analysis and a reagent, the fabrication precision of a forming mold, a transfer ability and a mold-release ability, the configuration of a microscopic flow passage is preferably made with a value within a range of 10 µm to 200 µm in width and depth. However, it is not limited specifically to the above value. Further, an aspect ratio (the depth of a groove / the width of the groove) is preferably about 0.1 to 3, more preferably about 0.2 to 2. The width and depth of a microscopic flow passage may be determined based on the usage of a microchip. In order to make explanation simple, the configuration of the cross section of the microscopic flow passage shown in Fig. 1 is made in a rectangular shape, but this configuration is one example of a microscopic flow passage and the configuration may be made in a curved shape.

Moreover, the board thickness of the resin-made base board 10 in which microscopic flow passages are formed is preferably about 0.2 mm to 5 mm in consideration of moldability, and more preferably 0.5 mm to 2 mm. The board thickness of the resin-made film 20 (seat-shaped member) which functions as a lid (a cover) to cover microscopic flow passages is preferably 30 µm to 300 µm, and more preferably 50 µm to 200 µm.

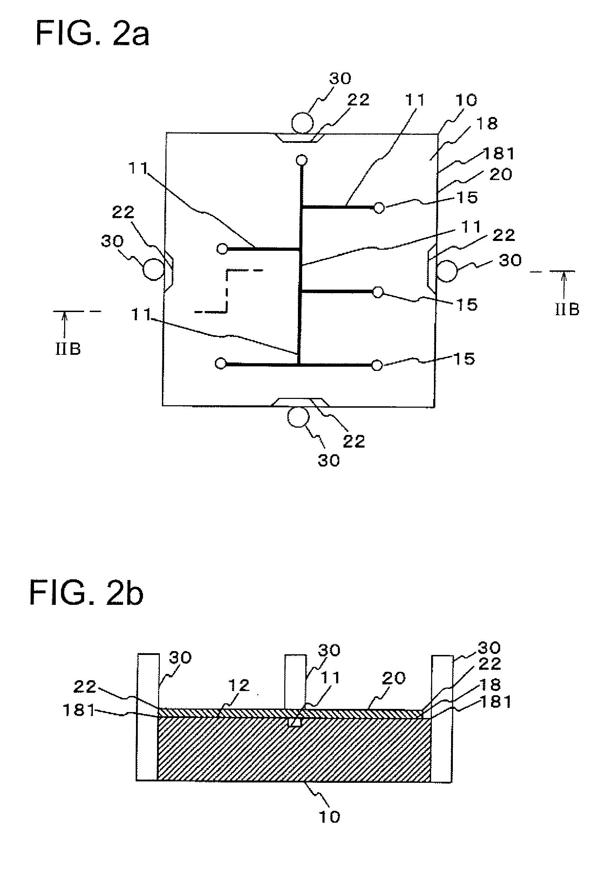

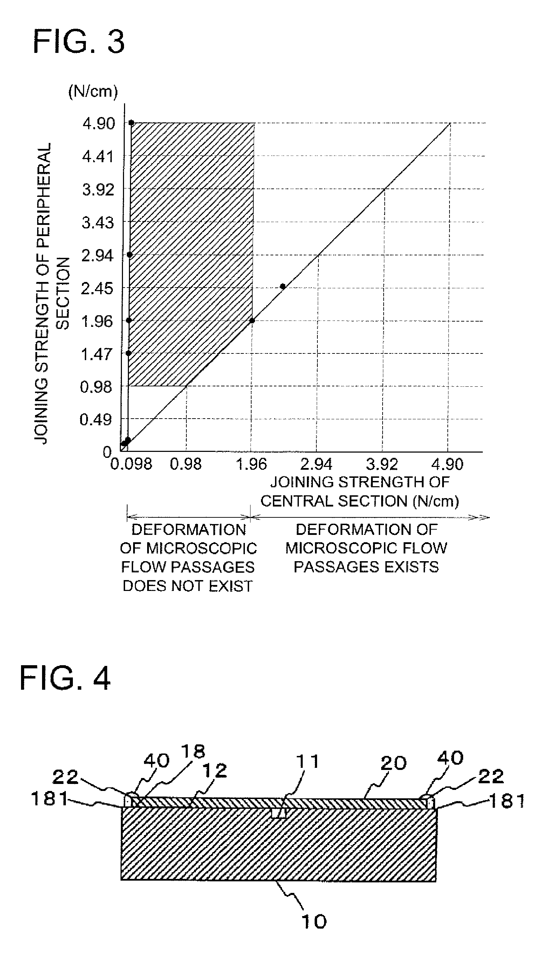

Next, with reference to Fig. 1 through Fig. 3, an explanation is made about the strength with which the resin-made film 20 is joined to the surface 12 of the resin-made base board 10. Fig. 2a is a plan view of a microchip in which an edge of a resin-made film is arranged inside toward a central region of a resin-made base board, that is, a plan view of a microchip in which on a region of at least a part including a side edge of the resin-made base board, provided is a non-joined region where a resin-made film is not provided. Fig. 2b is an IB-IB line cross sectional view of Fig. 2a, and Fig. 3 is a diagram showing a range in which the joining strength between a surface 12 of a resin-made base board 10 and a resin-made film 20 is different.

First, an explanation will be made about the definition of a central section 17 (it may be called a central region) and a peripheral section 18 (it may be called a peripheral region) in the joined surfaces of the resin-made base board 10 and the resin-made film 20 is explained. The central section 17 of the joined surfaces of the resin-made base board 10 and the resin-made film 20 corresponds to the region in which the groove 11 for flow passage and the through hole 15 of the surface 12 are formed and the area surrounding the region. Here, the range of the area surrounding the region is not limited specifically. However, the central section 17 has an area range including the groove 11 for flow passage and the through hole 15 without coming in contact with at least the end edge of the resin-made film 20.

Further, the peripheral section 18 in the joined surfaces of the resin-made base board 10 and the resin-made film 20 corresponds to the region from the outer periphery of the abovementioned central section 17 to the side edge of the resin-made film 20.

The joining strength in the joined surfaces of the resin-made base board 10 and the resin-made film 20 can be adjusted suitably as long as it is in the range that the deformation of microscopic flow passages does not occur. However, if the joining strength is too weak, it may become the cause of liquid leakage. Therefore, it is necessary to make the joining strength larger than 0.098 N/cm. Further, the joining strength of the joined surfaces in the central section 17 in which microscopic flow passages are provided may become different depending on the material, thickness, etc. of the resin-made base board 10. However, it is desirable from the viewpoint of suppressing the deformation of flow passages that the joining strength is smaller than 1.96 N/cm. Therefore, the joining strength at the central section 17 on the joined surfaces is preferably made in the range of from 0.098 to 1.96 N/cm.

In order to prevent liquid leakage and film peel-off effectively, the joining strength at the peripheral section 18 on the joined surfaces of the resin-made base board 10 and the resin-made film 20 is required to be made larger than that at the central section 17. In the peripheral section 18, even if the joining strength is made strong, there is no possibility that the deformation of flow passages is caused. Therefore, the upper limit of the joining strength is not limited. However, in the case where the joining strength at the peripheral section 18 is strengthened by rejoining, if heat and pressure are applied excessively, the resin-made base board 10 itself may deform greatly such that the deformation influences positioning at the time of analysis. Therefore, it is desirable to adjust the joining strength within the range that the resin-made base board 10 does not deform. The most desirable joining strength is made such that the joining strength at the central section 17 of the joined surfaces is made to the maximum joining strength within the range that the deformation of flow passages is not caused and the joining strength at the peripheral section 18 is made larger than the joining strength of the central section 17.

The range of the joining strength at the central section 17 on the joined surfaces of the resin-made base board 10 and the resin-made film 20 and the range of the joining strength at the peripheral section 18 on the joined surfaces, which are explained above, correspond to a range which are indicated with hatching in Fig. 3.

Hereafter, the joining strength at the central section 17 on the joined surfaces of the resin-made base board 10 and the resin-made film 20 is merely called "joining strength related to the central section 17 on the joined surfaces". Also, the joining strength at the peripheral section 18 on the joined surfaces of the resin-made base board 10 and the resin-made film 20 is merely called "joining strength related to the peripheral section 18 on the joined surfaces".

Incidentally, in the present invention, it may be permissible that the joining strength of at least a part of the peripheral section 18 on the joined surfaces is larger than the joining strength related to the central section 17 on the joined surfaces and the joining strength of parts other than the above part at the peripheral section 18 is the same as the joining strength related to the central section 17 on the joined surfaces. With this, even in the case where operators touch the peripheral section of a microchip directly, if the joining strength of the touched region is strengthened, the resin-made film 20 can be prevented from being peeled off.

When a microchip is handled, and when the resin-made film 20 is joined, there is a possibility that the end edge 22 of the resin-made film 20 is touched directly by operators and is peeled off from the resin-made base board 10. Examples of structures to prevent the resin-made film 20 from being peeled off, include a structure to make the end edge 22 of the resin-made film 20, i.e., the end edge of the joined surfaces of the resin-made base board 10 and the resin-made film 20 not to be touched directly by operators, and a structure to make the joining strength related to the peripheral section 18 on the joined surfaces larger than that of the joining strength related to the central section 17 of the joined surfaces.

Hereafter, an explanation will be made about the structure to make the end edge 22 of the resin-made film 20 not to be touched directly by operators with reference to Figs. 1 and 2. One example of a microchip to make the end edge 22 of the resin-made film 20 not to be touched directly with a positioning pin 30 is shown in Fig. 1.

Fig. 1 shows a microchip in which four sides being the side edges 181 of the peripheral section 18 of the resin-made base board 10 are made to come in contact with four positioning pins 30 respectively so that the position of the resin-made base board 10 is determined. In the microchip shown in Fig. 1, each of the end edges 22 (four sides) of the resin-made film 20 is provided with a non-joined surface, on which the resin-made film 20 is not provided, in a region which is within the side edges 181 of the surface 12 of the resin-made base board 10 and includes the side edges 181 (four sides). The width of the non-joined surface from the end edge 22 of the above-mentioned resin-made base board is about 0.25 mm, for example. The fixed length can be suitably adjusted in accordance with the configuration of a positioning jig of a microchip.

Here, although Fig. 1 shows the microchip in which the non-joined surface is provided for the outside of each of the end edges 22 (four sides) of the resin-made film 20, the microchip may be structured such that the non-joined surface on which the resin-made film 20 is not provided is provide on at least a part of the region including the side edges 181 of the surface 12 of the resin-made base board 10.

In Fig. 2, the non-joined surface on which the resin-made film 20 is not provided is provided on a region including one of the side edges 181 (four places) of the resin-made base board 10 corresponding in position to the four positioning pins 30. In this case, the position of the non-joined surface may be determined in accordance with the positions of the positioning pins 30. However, it is not limited to the positions of the positioning pins. For example, the non-joined surface on which the resin-made film 20 is not provided may be provided at a position where operators may directly touch the resin-made film 20 when the operators handle the micro chip, for example, a corner. According to the above structure, since operators do not touch the resin-made film 20 directly, it becomes possible to prevent effectively the peel-off of the resin-made film 20 and liquid leakage.

Next, with reference to Fig. 4, an explanation is made about the structure to make the joining strength at the peripheral section 18 on the joined surfaces of the resin-made base board 10 and the resin-made film 20 to be larger than the joining strength related to the central section 17 on the joined surfaces. Fig. 4 is a cross sectional view of a microchip in which a resin-made film 20 joined to the surface 12 of the resin-made base board 10 is rejoined with adhesives 40. Fig. 4 shows the microchip in which the resin-made film 20 is joined to the surface 12 of the resin-made base board 10 and all (four sides) of the end edges 22 of the joined resin-made film 20 are rejoined with adhesives 40.

Here, a part of the end edges 22 of the resin-made film 20 may be rejoined with adhesives 40. Further, the kind of the adhesives 40 may be suitably chosen in accordance with the material of the resin-made base board 10 and the resin-made film 20. Furthermore, the method of rejoining the resin-made film 20 to the resin-made base board 10 is not limited to the adhesives 40. For example, it may utilize a laser welding, a high frequency welding, a heat pad welding, an ultrasonic welding, etc.

Furthermore, in the microchip shown in Figs. 1 or 2 in which the non-joined surface on which the resin-made film 20 is not provided is provided in the region which locates within the side edges 181 (four sides) of the surface 12 of the resin-made base board 10 and includes the side edges 181 (four sides), it is desirable to rejoin a part or all periphery of the end edges 22 of the resin-made film 20 with adhesives 40.

According to the above structure, by the rejoining, it is possible to enlarge the strength with which the resin-made film 20 is joined to the peripheral section 18 of the resin-made base board 10. Therefore, even in the case where operators touch the resin-made film 20 directly, it becomes possible to prevent the resin-made film 20 from being peeled off.

Next, a producing method of a microchip will be explained. The production method produces a resin-made base board 10 and a resin-made film 20 respectively, and joins the resin-made base board 10 and the resin-made film 20.

The resin-made base board 10 is molded in a predetermined size and thickness with an injection molding machine. At the time of the injection molding, the groove 11 for flow passage and the through hole 15 are simultaneously formed. However, the groove 11 for flow passage and the through hole 15 may be formed after the injection molding. Further, a film with a prescribed thickness is cut into a predetermined size, whereby the resin-made film 20 is produced.

The joining of the resin-made base board 10 and the resin-made film 20 includes a first joining process to join a resin-made film so as to form the joined surfaces which consists of a central region including a region in which the above-mentioned groove for flow passages are formed and a peripheral region corresponding to the outer periphery of the central region. Further, after the first joining process, a second joining process may be included so as to rejoin the resin-made film 20 joined to the surface 12 of the resin-made base board 10 on at least a part of the peripheral section 18 of the surface 12 of the resin-made base board 10.

In the joining of the resin-made base board 10 and the resin-made film 20, whether the second joining process is included or not may be suitably chosen based on whether the non-joined surface on which the resin-made film 20 is not provided is provided or not in a region including side edges 181 (each side) of the resin-made base board 10 in the microchip.

### (Peel-off test)

Next, the peel-off test of a microchip in order to measure the joining strength in the present invention will be explained.

In order to evaluate a joining strength of a resin-made film to a resin-made base board, the joining strength is measured in accordance with the 90° peel-off method specified in JIS Z 0237.

At the time ofmeasuring the joining strength in the present invention, in order to secure a part to be peeled off on a resin-made film of a microchip to which the resin-made film was joined, a film made of the same component as the resin-made film is cut out such that at least one of four sides of the film become larger by about 10 mm than the resin-made base board, and the film is joined firmly onto the resin-made film of the microchip with an adhesive having a powerful joining force. Then, the resin-made film with a length of 10mm projected from the resin-made base board is pinched with a jig and is pulled vertically at 90 degrees. At this time, the peeling weight is divided by the joint width of the peeled-offjoined surfaces and the resultant value is made as the joining strength. The average value when the resin-made film is peeled off by 2 mm from the end of the joined surfaces is made as the joining strength of the peripheral region of the joined surfaces. After the resin-made film is peeled from the peripheral region of the joined surfaces, the average value when the resin-made film is peeled off by 2 mm from the central region (center of gravity) of the joined surfaces is made as the joining strength of the central region of the micro chip.

### (Rejoining of the peripheral region)

Next, the rejoining of the periphery of a microchip is explained.

As a method of strengthening only the peripheral region of the joined surfaces of a resin-mad base board and a resin-made film, adhesives, a laser welding, a high frequency welding, a heat pad welding, an ultrasonic welding, etc. may be employed. However, the method is not limited to these methods and the method to strengthen only the joining force of a peripheral region of a micro chip may be permissible.

### (Material of a base board and a film)

Next, the material of the resin-made base board 10 and the resin-made film 20 will be explained. Examples of the material of the resin-made base board 10, without being limited thereto specifically, include polyolefin system resin, polyethylene system resin, acrylic resin, silicone resin, polycarbonate system resin and the like. Particularly, acrylic resins, such as polymethylmethacrylate (PMMA), are employed preferably. Examples of the acrylic resins include Acrypet manufactured by Mitsubishi Rayon Co., Ltd., Sumipex manufactured by Sumitomo Chemical Co., Ltd, Delpet manufactured by Asahi Kasei Corporation, and Parapet manufactured by Kuraray Co., Ltd. As the material of the resin-made film 20, the resin similar to that of the resin-made base board can be employed and there is no limitation in particular. However, an acrylic resin is employed preferable. Examples of the acrylic resin used for the resin-made film include Acryplen manufactured by Mitsubishi Rayon Co., Ltd., Technoloy manufactured by Sumitomo Chemical Co., Ltd, and Sundulen manufactured by Kaneka Corporation, etc. However, the materials of the resin-made base board 10 and the material of the resin-made film 20 are not limited to the above materials.

### [EXAMPLE]

Next, With reference to Fig. 1 and Table 1, concrete embodiments and comparative examples are explained. Table 1 is a table showing the preparation conditions and evaluation results of microchips.

Hereafter, each of examples will be explained. Example 1 through Example 5 each shows an example in which rejoining was conducted after the resin-made base board 10 and the resin-made film 20 were joined. Example 6 shows an example in which rejoining was not conducted after he resin-made base board 10 and the resin-made film 20 were joined.

### (Joining of a microchip)

In the production of the resin-made base board 10, it was produced with acrylic resin (Delpet 70NH manufactured by Asahi Kasei Corporation) by an injection molding machine, whereby plural grooves 11 I for flow passages with a width of 50 µm and a depth of 50 µm and plural through holes 15 with an inside diameter of 2 mm were formed on a plate-shaped member with external dimensions of 50.0 mm x 50.0 mm x 1 mm.

In the production of the resin-made film 20, an acrylic resin film (Acryplen manufactured by Mitsubishi Rayon Co., Ltd., with a thickness of 75 µm) was cut into 50.0 mm x 50.0 mm. The resin-made base board 10 had a dimension difference of 0.0 mm in both of longitudinal and transverse directions for the resin-made film 20.

In the joining of the resin-made base board 10 and the resin-made film 20, the resin-made film 20 was superimposed correctly on the surface 12 of the resin-made base board 10 is which the grooves 11 for flow passage were formed, and the entire area of the resin-made-film 20 was joined with pressure by a force of 98 N/cm² at a pressing temperature of 90 °C with a heat pressing machine, whereby the resin-made base board 10 and the resin-made film 20 were joined with each other.

In the rejoining of the resin-made base board 10 and the resin-made film 20, the periphery of the joined surfaces (four sides) was coated with UV adhesive 40 for acrylic (OPM55 manufactured by Adell Corporation), and the UV adhesive 40 was cured by being irradiated with UV light of 3000 mJ.

### (Measurement of the joining strength)

As a result of the measurement that the joining strength of the central region and the joining strength of the peripheral region on the joined surfaces were measured respectively, the joining strength at the central region on the joined surfaces was 0.147 N/cm, and the joining strength at the peripheral region on the joined surfaces was 4.9 N/cm.

### (Microchip evaluation after the joining)

After the resin-made base board 10 and the resin-made film 20 were rejoined, a visual inspection, a liquid leakage test and a slide test for microchip were conducted.

### (Slide test)

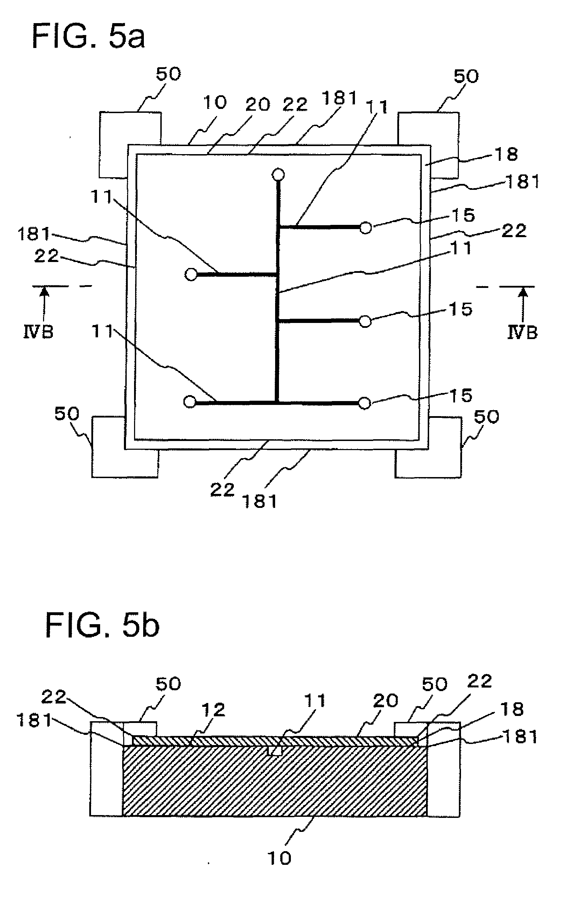

The procedure of the slide test is explained with reference to Fig. 5. Fig. 5a is an explanatory drawing of the slide test for a microchip by the use of a positioning jig 50, and Fig. 5b is a VB-VB line cross sectional views of Fig. 5a.

It can be considered to apply a microchip for a medical diagnosis (protein, DNA analysis) with the utilization of the feature that a microchip is cheap and can be produced in large volume. In order to reduce the cost per one diagnosis, it is desirable to automate an analyzing system, and also it is desirable to load a microchip automatically. In this case, since it is necessary to focus a laser beam onto a detection section of a flow passage having a width of several tens µm, setting and positioning of a microchip must be conducted precisely. At this time, it may be considered that a film is peeled off due to the friction of a positioning tool. Then, in order to evaluate the resistance of a film to peel-off, the slide test illustrated in Fig. 5 was conducted with the supposition for an actual automatic analyzing device.

The positioning jigs 50 were arranged at four corners of a microchip as shown in Figs. 5a and 5b. The positioning jigs 50 were installed such that the inside dimensions of them were larger by 20 µm than the outside dimensions of the resin-made base board 10. An operation to insert a microchip with a resin-made film 20 pasted thereon into the positioning jigs 50 from the vertical direction and to take it out from the positioning jigs 50 was conducted for 10 microchips, and observation was made for the change of the joined condition of the resin-made film 20.

Even if only one sheet was peeled off among ten sheets of resin-made films 20, since it becomes impossible to incorporate the resin-made film 20 into an automatic analyzing device from the viewpoint of the reliability of the test, the case where only zero sheet was peeled off was made acceptable.

### (Liquid leakage test)

Now, a liquid leakage test will be explained.

The liquid leakage test was conducted for the produced microchips by the use of a water-based ink (blue black manufactured by Pilot Corporation). To be more concrete, after each flow passage and through holes 15 were filled with the water-based ink and were left at ordinary temperature for 24 hours, whether the water-based ink was leaked from the periphery of the flow passages and the periphery of the through holes 15 was checked by the use of a microscope. In the case where the bleeding of ink was observed, the case was considered as B (bad) and in the case where the bleeding of ink was not observed, the case was considered as A (good).

In the visual inspection for microchips, the joined surfaces and microscopic flow passages of each microchip were observed. Since a portion influenced by the rejoining is only the peripheral region of a microchip, the deformation of microscopic flow passages did not take place. Further, in the liquid leakage test and the slide test for the microchips, it was confirmed that there was no problem in any point.

It was judged from the above-mentioned results that the microchips produced on the condition of Example 1 can be provided for practical use. The evaluation results ofthe microchips in Example 1 are shown in Table 1.

**Table 1**

| | Producing condition | | | Evaluation items | | | | | |
|---|---|---|---|---|---|---|---|---|---|
| | Heat joining condition for the entire body of a chip | Rejoining condition for a peripheral section of a chip | Dimensional difference of a base board fro a film | External appearance of joined surfaces (air bubbles) | External appearance of flow passages (deformation) | Peel-off test (central section, N/cm) | Peel-off test (peripheral section, N/cm) | Liquid leakage test (24h) | Slide test (the number of peel-of chips |
| Comparative example 1 | 90°C, 9.8N/cm² | None | 0.0mm | B | A | 0.072 | 0.072 | B | 5/10 |
| Comparative example 2 | 90°C, 98N/cm² | None | 0.0mm | A | A | 0.147 | 0.147 | A | 3/10 |
| Comparative example 3 | 104°C, 98N/cm² | None | 0.0mm | A | B | 2.45 | 2.45 | A | 0/10 |
| Comparative example 4 | 90°C,1964N/cm² | None | 0.0mm | A | B | 1.96 | 1.96 | A | 0/10 |
| Example 1 | 90°C, 98N/cm² | Adhesive | 0.0mm | A | A | 0.147 | 4.9 | A | 0/10 |
| Example 2 | 90°C,, 98N/cm² | Laser welding | 0.0mm | A | A | 0.147 | 1.47 | A | 0/10 |
| Example 3 | 90°C, 98N/cm² | High frequency welding | 0.0mm | A | A | 0.147 | 1.96 | A | 0/10 |
| Example 4 | 90°C, 98N/cm² | Heat pad welding | 0.0mm | A | A | 0.147 | 2.94 | A | 0/10 |
| Example 5 | 90°C, 98N/cm² | Ultrasonic welding | 0.0mm | A | A | 0.147 | 2.94 | A | 0/10 |
| Example 6 | 90°C, 98N/cm² | None | +0.5mm | A | A | 0.147 | 0.147 | A | 0/10 |

### (Example 2)

Next, Example 2 is explained.

### (Joining of a microchip)

The production of the resin-made base board 10 and the production of the resin-made film 20 were the same as those in Example 1. Further, the joining of the resin-made base board 10 and the resin-made film 20 was also the same as that in Example 1.

However, the rejoining of the resin-made base board 10 and the resin-made film 20 was different from that in Example 1. Namely, an absorbent (G ink manufactured by Orient Chemical Industries Co., Ltd.,) was coated onto the periphery (four sides) of the resin-made film 20 by a dispenser so as not to run off to the outside of the resin-made base board 10. Then, the absorbent was irradiated with an infrared laser beam for 3000 mJ so that the absorbent generated heat locally, whereby the end edge of the resin-made film 20 coming in contact with the absorbent was melt and joined with a part of the resin-made base board 10.

As a result of the measurement that the joining strength of the central region and the joining strength of the peripheral region on the joined surfaces were measured respectively, the joining strength at the central region on the joined surfaces was 0.147 N/cm, and the joining strength at the peripheral region on the joined surfaces was 1.47 N/cm.

### (Microchip evaluation after the joining)

After the resin-made base board 10 and the resin-made film 20 were rejoined, a visual inspection, a liquid leakage test and a slide test for microchip were conducted.

In the visual inspection for microchips, the joined surfaces and microscopic flow passages of each microchip were observed. Since a portion influenced by the rejoining is only the peripheral region of a microchip, the deformation of microscopic flow passages did not take place. Further, in the liquid leakage test and the slide test for the microchips, it was confirmed that there was no problem in any point.

It was judged from the above-mentioned results that the microchips produced on the condition of Example 2 can be provided for practical use. The evaluation results of the microchips in Example 2 are shown in Table 1.

### (Example 3)

Next, Example 3 is explained.

### (Joining of a microchip)

The production of the resin-made base board 10 and the production of the resin-made film 20 were the same as those in Example 1. Further, the joining of the resin-made base board 10 and the resin-made film 20 was also the same as that in Example 1.

However, the rejoining of the resin-made base board 10 and the resin-made film 20 was different from those in Example 1 and Example 2. Namely, the periphery (four sides) of the resin-made film 20 was melt and joined with a high frequency of 41 MHz and a power of 3 W by the use of a high frequency welder.

As a result of the measurement that the joining strength of the central region and the joining strength of the peripheral region on the joined surfaces were measured respectively, the joining strength at the central region on the joined surfaces was 0.147 N/cm, and the joining strength at the peripheral region on the joined surfaces was 1.96 N/cm.

### (Microchip evaluation after the joining)

After the resin made base board 10 and the resin-made film 20 were rejoined, a visual inspection, a liquid leakage test and a slide test for microchip were conducted.

In the visual inspection for microchip, the joined surfaces and microscopic flow passages of each microchip were observed. Since a portion influenced by the rejoining is only the peripheral region of a microchip, the deformation of microscopic flow passages did not take place. Further, in the liquid leakage test and the slide test for the microchips, it was confirmed that there was no problem in any point.

It was judged from the above-mentioned results that the microchips produced on the condition of Example 3 can be provided for practical use. The evaluation results of the microchips in Example 3 are shown in Table 1.

### (Example 4)

Next, Example 4 is explained.

### (Joining of a microchip)

The production of the resin-made base board 10 and the production of the resin-made film 20 were the same as those in Example 1. Further, the joining of the resin-made base board 10 and the resin-made film 20 was also the same as that in Example 1.

However, the rejoining of the resin-made base board 10 and the resin made film 20 was different from those in Example 1 through Example 3. Namely, only the periphery (four sides) of the resin-made film 20 was melted and rejoined to the resin-made base board 10 by the use of a heat pad welding.

As a result of the measurement that the joining strength of the central region and the joining strength of the peripheral region on the joined surfaces were measured respectively, the joining strength at the central region on the joined surfaces was 0.147 N/cm, and the joining strength at the peripheral region on the joined surfaces was 2.94 N/cm.

### (Microchip evaluation after the joining)

After the resin-made base board 10 and the resin-made film 20 were rejoined, a visual inspection, a liquid leakage test and a slide test for microchip were conducted.

In the visual inspection for microchips, the joined surfaces and microscopic flow passages of each microchip were observed. Since a portion influenced by the rejoining is only the peripheral region of a microchip, the deformation of microscopic flow passages did not take place. Further, in the liquid leakage test and the slide test for the microchips, it was conformed that there was no problem in any point.

It was judged from the above-mentioned results that the microchips produced on the condition of Example 4 can be provided for practical use. The evaluation results ofthe microchips in Example 4 are shown in Table 1.

### (Example 5)

Next, Example 5 is explained.

### (Joining of a microchip)

The production of the resin-made base board 10 and the production of the resin-made film 20 were the same as those in Example 1. Further, the joining of the resin-made base board 10 and the resin-made film 20 was also the same as that in Example 1.

However, the rejoining of the resin-made base board 10 and the resin-made film 20 was different from those in Example 1 through Example 4. Namely, the end portion (four sides) of the film was melt and joined with ultrasonic of 21 kHz and power of 3 W by the use of a ultrasonic welding device.

As a result of the measurement that the joining strength of the central region and the joining strength of the peripheral region on the joined surfaces were measured respectively, the joining strength at the central region on the joined surfaces was 0.147 N/cm, and the joining strength at the peripheral region on the joined surfaces was 2.94 N/cm.

### (Microchip evaluation after the joining)

After the resin-made base board 10 and the resin-made film 20 were rejoined, a visual inspection, a liquid leakage test and a slide test for microchip were conducted.

In the visual inspection for microchips, the joined surfaces and microscopic flow passages of each microchip were observed. Since a portion influenced by the rejoining is only the peripheral region of a microchip, the deformation of microscopic flow passages did not take place. Further, in the liquid leakage test and the slide test for the microchips, it was confirmed that there was no problem in any point.

It was judged from the above-mentioned results that the microchips produced on the condition of Example 5 can be provided for practical use. The evaluation results of the microchips in Example 5 are shown in Table 1.

### (Example 6)

Next, Example 6 is explained.

### (Joining of a microchip)

The production of the resin-made base board 10 was the same as those in Example 1. In the production of the resin-made film 20, an acrylic resin film (Acryplen manufactured by Mitsubishi Rayon Co., Ltd., with a thickness of 75 µm) was cut into 49.5 mm x 49.5 mm. The resin-made base board 10 had a dimension difference of +0.5 mm in both of longitudinal and transverse directions for the resin-made film 20.

In the joining of the resin-made base board 10 and the resin-made film 20, after the positioning was conducted precisely so that the centers of both of the resin-made base board 10 and the resin-made film 20 were overlapped to each other, the resin-made film 20 was superimposed on the surface 12 of the resin-made base board 10 in which the grooves 11 for flow passage were formed, and the entire area of the resin-made-film 20 was joined with pressure by a force of 98 N/cm² at a pressing temperature of 90 °C with a heat pressing machine, whereby the resin-made base board 10 and the resin-made film 20 were joined with each other. It is the same as that of Example1.

In Example 6, the rejoining of the resin-made base board 10 and the resin-made film 20 was not conducted. In this regard, Example 6 was different from any one of Example 1 through Example 5.

### (Measurement of the joining strength)

As a result of the measurement that the joining strength of the central region and the joining strength of the peripheral region on the joined surfaces were measured respectively, the joining strength at all of the central region and the peripheral region on the joined surfaces was 0.147 N/cm.

### (Microchip evaluation after the joining)

After the resin-made base board 10 and the resin-made film 20 were rejoined, a visual inspection, a liquid leakage test and a slide test for microchip were conducted.

In the visual inspection for microchips, the joined surfaces and microscopic flow passages of each microchip were observed. As a result, incorporation of air bubbles and the deformation of microscopic flow passages were not observed. In the liquid leakage test of the microchips, it was confirmed that there was no problem.

Further, in the slide test of the microchips, even if the test was conducted by 10 times, the resin-made film 20 was not peeled off once. The reason is that since the dimensions of the resin-made film 20 are 49.5 mm x 49.5 mm smaller by 0.5 mm than those of the resin-made base board 10 being 50.0 mm x 50.0 mm, the perimeter (four sides) of the resin-made film 20 was joined to the center-section 17 side of the resin-made base board 10 by 0.25 mm for the periphery (four sides) of the resin-made base board 10. Therefore, the resin-made film 20 never comes in contact with the positioning jigs 50. Furthermore, at the time of handling a microchip, the end edge 22 of the resin-made film 20 was hardly peeled off with a normal operation. The evaluation results of the microchips in Example 6 are shown in Table 1.

The materials of the microchips and the producing methods shown in Example 1 through Example 6 are one example, and the present invention is not limited to these.

### [Comparative example]

Next, Comparative examples will be explained.

The following Comparative examples are examples in the case where the rejoining is not conducted after the joining of the resin-made base board 10 and the resin-made film 20. Here, in Comparative example, an explanation will be omitted about the overlapping content.

### (Joining of a microchip)

The production of the resin-made base board 10 and the production of the resin-made film 20 were the same as those in Example 1.

In the joining of the resin-made base board 10 and the resin-made film 20, the resin-made film 20 was superimposed correctly on the surface 12 of the resin-made base board 10 in which the grooves 11 for flow passage were formed, and the resin-made-film 20 was joined with pressure by a force of 9.8 N/cm² at a pressing temperature of 90 °C with a heat pressing machine, whereby the resin-made base board 10 and the resin-made film 20 were joined with each other. Herein, the rejoining of the resin-made base board 10 and the resin-made film 20 was not conducted.

### (Measurement of the joining strength)

As a result of the measurement that the joining strength of the central region and the joining strength of the peripheral region on the joined surfaces were measured respectively, the joining strength at all of the central region and the peripheral region on the joined surfaces was 0.072 N/cm.

### (Microchip evaluation after the joining)

After the resin-made base board 10 and the resin-made film 20 were joined, a visual inspection, a liquid leakage test and a slide test for microchip were conducted.

In the visual inspection for microchips, as a result of inspection by a microscope, it was observed that air bubbles remained on the joined surfaces of the microchips. From the remaining air bubbles, since it is worried that the reliability becomes lower under high temperature and high humidity, it is not preferable. Further, when the microscopic flow passages were observed by a scanning type confocal laser microscope OLS3000 manufactured by Olympus Corporation, no deformation of the microscopic flow passages was observed.

In the liquid leakage test of the microchips, liquid leakage was observed. Further, in the slide test of the microchips, peel-off from the peripheral section 18 of the resin-made base board 10 took place in five microchips among ten microchips.

It was judged from he above-mentioned results that the microchips produced on the condition of Comparative example 1 cannot be provided for practical use in the points that air bubbles remain on the joined surfaces, liquid leakage takes place and peel-off of a resin-made film 20 takes place. The evaluation results ofthe microchips in Comparative example 1 are shown in Table 1.

### (Comparative example 2)

Next, Comparative example 2 is explained.

### (Joining of a microchip)

The production of the resin-made base board 10 was the same as that in Comparative example 1 (Example 1). Further, the production of the resin-made film 20 was the same as that of Comparative example 1.

However, the joining of the resin-made base board 10 and the resin-made film 20 was different from that in Comparative example 1. Namely, in order to increase a joining force than Comparative example 1, microchips were produced by changing the pressing force of the heat pressing machine from 9.8 N/cm² to 98 N/cm².

### (Measurement of the joining strength)

As a result of the measurement that the joining strength of the central region and the joining strength of the peripheral region on the joined surfaces were measured respectively, the joining strength at all of the central region and the peripheral region on the joined surfaces was 0.147 N/cm.

### (Microchip evaluation after the joining)

After the resin-made base board 10 and the resin-made film 20 were joined, a visual inspection, a liquid leakage test and a slide test for microchip were conducted.

In the visual inspection for microchips, no remaining air bubble was observed. Further, in the liquid leakage test of the microchips, it was confirmed that there was no problem.

However, in the slide test of the microchips, peel-off from the peripheral section of the microchip took place in three microchips among ten microchips.

It was judged from the above-mentioned results that the microchips produced on the condition of Comparative example 2 cannot be provided for practical use in the points that peel-offofa resin-made film 20 takes place. The evaluation results of the microchips in Comparative example 2 are shown in Table 1.

### (Comparative example 2)

Next, Comparative example 3 is explained.

### (Joining of a microchip)

The production of the resin-made base board 10 was the same as that in Comparative example 1 and Comparative example 2 (Example 1). Further, the production of the resin-made film 20 was the same as that of Comparative example 1 and Comparative example 2.

However, the joining of the resin-made base board 10 and the resin-made film 20 was different from that in Comparative example 1 and Comparative example 2. Namely, in order to increase a joining force than Comparative example 1 and Comparative example 2, microchips were produced by changing the heating temperature of the heat pressing machine from 90°C to 104°C with a pressing force of 98 N/cm².

### (Measurement of the joining strength)

As a result of the measurement that the joining strength of the central region and the joining strength of the peripheral region on the joined surfaces were measured respectively, the joining strength at the central region and the peripheral region on the joined surfaces was 2.45 N/cm.

### (Microchip evaluation after the joining)

After the resin-made base board 10 and the resin-made film 20 were joined, a visual inspection, a liquid leakage test and a slide test for microchip were conducted.

In the liquid leakage test of the microchips, it was confirmed that there was no problem.

Further, in the slide test of the microchips, peel-off took place no microchip.

However, in the visual inspection of the microchips, although no remaining air bubble was observed, the deformation of microscopic flow passages due to the influence of the heating temperature of the heat pressing machine was observed.

It was judged from the above-mentioned results that the microchips produced on the condition of Comparative example 3 cannot be provided for practical use in the points that the deformation of microscopic flow passages takes place. The evaluation results of the microchips in Comparative example 3 are shown in Table 1.

### (Comparative example 4)

Next, Comparative example 4 is explained.

### (Joining of a microchip)

The production of the resin-made base board 10 was the same as that in Comparative example I through Comparative example 3 (Example 1). Further, the production of the resin-made film 20 was the same as that of Comparative example 1 through Comparative example 2.

However, the joining of the resin-made base board 10 and the resin-made film 20 was different from that in Comparative example 1 through Comparative example 2. Namely, in order to increase a joining force from the results of Comparative example 1 through Comparative example 3, microchips were produced by changing the pressing force from 98 N/cm² to 160 N/cm² at a heating temperature of 90°C in the heat pressing machine.

### (Measurement of the joining strength)

As a result of the measurement that the joining strength of the central region and the joining strength of the peripheral region on the joined surfaces were measured respectively, the joining strength at the central region and the peripheral region on the joined surfaces was 1.96 N/cm.

### (Microchip evaluation after the joining)

After the resin-made base board 10 and the resin-made film 20 were joined, a visual inspection, a liquid leakage test and a slide test for microchip were conducted.

In the liquid leakage test of the microchips, it was confirmed that there was no problem. However, in the visual inspection of the microchips, although no remaining air bubble was observed, the deformation of microscopic flow passages due to the influence of the heating temperature of the heat pressing machine was observed.

It was judged from the above-mentioned results that the microchips produced on the condition of Comparative example 4 cannot be provided for practical use in the points that the deformation of microscopic flow passages takes place. "The evaluation results of the microchips in Comparative example 4 are shown in Table 1.

In the above, Examples and Comparative examples were explained. In Examples, it turns out that when the resin-made film 20 joined to the resin-made base board 10 is rejoined to the peripheral section 18 of the resin-made base board 10, the generation of air bubbles at the joined surfaces can be avoided and the deformation of microscopic flow passages can be avoided, and in addition, a predetermined joining force can be obtained. On the other hand, in Comparative examples, it turns out that that only with the structure that the resin-made film 20 is merely joined to the resin-made base board 10, air bubbles remain on the joined surfaces, the deformation of microscopic flow passages take place and a predetermined joining force cannot be obtained.

## Claims

1. In a microchip which comprises a resin-made base board having a first surface in which grooves for flow passages are formed and a second surface at the opposite side of the first surface, and a resin-made film joined to the first surface of the resin-made base board, the microchip is **characterized in that** the joined surfaces of the resin-made base board and the resin-made film consists of a central region including a region in which the grooves for flow passages are formed and a peripheral region corresponding to the outer periphery of the central region, the joining strength of the resin-made base board and the resin-made film in the central region is larger than 0.098 N/cm, and the joining strength of at least a part of the peripheral region of the joined surfaces is larger than the joining strength of the central region.

2. The microchip described in claim 1 is **characterized in that** a non joined region in which the resin-made film is not provided is provided in a partial region including a side edge of the first surface of the resin-made base board.

3. A microchip which comprises a resin-made base board having a first surface in which grooves for flow passages are formed and a second surface at the opposite side of the first surface, and a resin-made film joined to the first surface of the resin-made base board, the microchip is **characterized in that** the joining strength of the resin-made base board and the resin-made film is larger than 0.098 N/cm, and a non joined region in which the resin-made film is not provided is provided in a partial region including a side edge of the first surface of the resin made base board.

4. A producing method of a microchip **characterized by** comprising:
a first joining process to join a resin-made film on a first surface of a resin-made base board having the first surface in which grooves for flow passages are formed and a second surface at the opposite side of the first surface, thereby forming a central region including a region in which the grooves for flow passages are formed and a peripheral region corresponding to the outer periphery of the central region; and
a second joining process to strengthen the joining strength of at least a partial region of the peripheral region of the joined surfaces after the first joining process,
wherein the joining strength of the resin-made base board and the resin-made nim in the central region is larger film 0.098 N/cm.
